# EUROPEAN PATENT APPLICATION

(11) **EP 4 491 660 A1**
(43) Date of publication of application: **15.01.2025**
(21) Application number: 23779215.5
(22) Date of filing: 02.03.2023
(51) Int. Cl.: C08J 5/18, B32B 27/30, B65D 65/40, B65D 85/86

(54) **RESIN SHEET, CONTAINER, CARRIER TAPE, AND ELECTRONIC COMPONENT PACKAGING**

(30) Priority: 28.03.2022 JP 2022052422
(71) Applicant: Denka Company Limited, Tokyo 103-8338 (JP)
(72) Inventor: INODA, Ikuka, Tokyo 103-8338 (JP); YANAKA, Ryosuke, Tokyo 103-8338 (JP)
(74) Representative: Müller-Boré & Partner Patentanwälte PartG mbB
(86) International application number: PCT/JP2023/007898
(87) International publication number: WO 2023/189186

(57) **Abstract**

A resin sheet includes a base sheet containing a polystyrene-based resin, in which a maximum puncture elastic modulus calculated by the following procedure is 2.4 to 6.4 MPa.

[Calculation Procedure of Maximum Puncture Elastic Modulus]

A measurement sample is fixed to a flat plate-shaped jig having a hole with a diameter of 1.0 mm provided in the center portion, a load L (N) and a strain amount ε in a puncture direction when perpendicularly puncturing the surface of the measurement sample with a cylindrical needle having a diameter of 0.8 mm of which the tip is in the shape of a flat surface at a rate of 0.5 mm/minute are measured, and a value when a ratio of a stress difference to a strain amount difference calculated by Expression: (ΔL/S)/Δε (in the expression, S indicates the area (mm²) of the tip surface of the needle) is maximized at 0.1 ≤ ε ≤ 5.0 is set as the maximum puncture elastic modulus.

## Description

### Technical Field

The present invention relates to a resin sheet, a container, a carrier tape, and an electronic component packaging.

### Background Art

In a packaging container of an intermediate product of an industrial product such as an electronic device and an automobile, a vacuum-molded tray, an embossed carrier tape, and the like, obtained by performing heat molding on a resin sheet, are used. Then, as a sheet for a packaging container of an IC vulnerable to static electricity, and various components including the IC, a resin sheet having a laminated structure in which a surface layer containing a thermoplastic resin and a conductive material such as carbon black is laminated on a base layer consisting of a thermoplastic resin is used (for example, refer to Patent Literatures 1 to 3 described below).

In the production of the embossed carrier tape, an accommodation portion matching the shape of a component to be transported is provided by molding the resin sheet using a molding means such as press molding.

### Citation List

### Patent Literature

Patent Literature 1: Japanese Unexamined Patent Publication No. H9-76422
Patent Literature 2: Japanese Unexamined Patent Publication No. H9-76425
Patent Literature 3: Japanese Unexamined Patent Publication No. H9-174769

### Summary of Invention

### Technical Problem

Recently, various electronic components such as a capacitor or a resistor, an IC, a LED, a connector, and a switching element have been miniaturized. Since the size of the accommodation portion is miniaturized in the carrier tape for transporting such a miniaturized component, when mounting the electronic component, a nozzle for picking up the component is likely to be in contact with the carrier tape. In a case where the opening of the accommodation portion or the like is excessively deformed due to the contact with the nozzle, a pickup failure such as being unable to take out the component occurs. In addition, the pickup failure of the component may occur due to another factor. In a case where the miniaturized component accommodated in the accommodation portion is moved and tilted during transport, it is difficult to adsorb the component. Therefore, the molding of the accommodation portion of the miniaturized component is required to have a high accuracy.

An object of the present invention is to provide a resin sheet that is excellent in deformation resistance to a local load while having sufficient moldability, and a container, a carrier tape, and an electronic component packaging obtained by using the resin sheet.

### Solution to Problem

One aspect of the present invention relates to [1] to [7] described above.
[1] A resin sheet, including a base sheet containing a polystyrene-based resin, in which a maximum puncture elastic modulus calculated by a procedure described below is 2.4 to 6.4 MPa.

### [Calculation Procedure of Maximum Puncture Elastic Modulus]

A measurement sample is fixed to a flat plate-shaped jig having a hole with a diameter of 1.0 mm provided in a center portion, a load L (N) and a strain amount ε in a puncture direction when perpendicularly puncturing a surface of the measurement sample with a needle having a tip in the shape of a circular flat surface (a diameter of 0.8 mm) at a rate of 0.5 mm/minute are measured under an environment of 23°C, and a value when a ratio of a stress difference to a strain amount difference calculated by Expression: (ΔL/S)/Δε (in the expression, S indicates an area (mm²) of a tip surface of the needle) is maximized at 0.1 ≤ ε ≤ 5.0 is set as the maximum puncture elastic modulus.
[2] The resin sheet according to [1] described above, in which when performing dynamic viscoelasticity measurement, a storage modulus E'1 at 25°C is 1.0 × 10⁸ Pa or more and 1.0 × 10¹⁰ Pa or less, and a storage modulus E'2 at Loss Tangent Peak Temperature + 20°C is 1.0 × 10⁶ Pa or less.
[3] The resin sheet according to [1] or [2] described above, in which the base sheet contains one or more types of resins of a general-purpose polystyrene resin and an impact-resistant polystyrene resin in a total of 50% by mass or more, on the basis of a total amount of a styrene-based resin.
[4] A resin sheet, including a base sheet containing a thermoplastic resin, in which when performing dynamic viscoelasticity measurement, a storage modulus E'1 at 25°C is 1.0 × 10⁸ Pa or more and 1.0 × 10¹⁰ Pa or less, and a storage modulus E'2 at Loss Tangent Peak Temperature + 20°C is 1.0 × 10⁶ Pa or less.
[5] A container that is a compact of the resin sheet according to any one of [1] to [4] described above.
[6] A carrier tape that is a compact of the resin sheet according to any one of [1] to [4] described above and is provided with an accommodation portion capable of accommodating a commodity.
[7] An electronic component packaging, including: the carrier tape according to [6] described above; an electronic component accommodated in the accommodation portion of the carrier tape; and a cover film adhering to the carrier tape as a lid material.

In order to attain the object described above, one aspect of the present invention provides a resin sheet including a base sheet containing a polystyrene-based resin, in which a maximum puncture elastic modulus calculated by the following procedure is 2.4 to 6.4 MPa.

### [Calculation Procedure of Maximum Puncture Elastic Modulus]

A measurement sample is fixed to a flat plate-shaped jig having a hole with a diameter of 1.0 mm provided in the center portion, a load L (N) and a strain amount ε in a puncture direction when perpendicularly puncturing the surface of the measurement sample with a needle having a tip in the shape of a circular flat surface (a diameter of 0.8 mm) at a rate of 0.5 mm/minute are measured under an environment of 23°C, and a value when a ratio of a stress difference to a strain amount difference calculated by Expression: (ΔL/S)/Δε (in the expression, S indicates the area (mm²) of the tip surface of the needle) is maximized at 0.1 ≤ ε ≤ 5.0 is set as the maximum puncture elastic modulus.

According to the resin sheet, by the resin sheet containing the polystyrene-based resin and having the maximum puncture elastic modulus in the specific range, it is possible to have both of a characteristic that deformation due to a local load is less likely to occur and moldability that a compact can be obtained with a sufficient accuracy in the case of performing molding such as press molding. According to a carrier tape formed from such a resin sheet, in the use of transporting a miniaturized component, it is possible to include a favorably molded accommodation portion, sufficiently suppress deformation caused by contact with a pickup nozzle, and suppress the occurrence of the pickup failure.

In the resin sheet, when performing dynamic viscoelasticity measurement, a storage modulus E'1 at 25°C may be 1.0 × 10⁸ Pa or more and 1.0 × 10¹⁰ Pa or less, and a storage modulus E'2 at Loss Tangent Peak Temperature + 20°C may be 1.0 × 10⁶ Pa or less.

In addition, the base sheet may contain one or more types of resins of a general-purpose polystyrene resin and an impact-resistant polystyrene resin in a total of 50% by mass or more, on the basis of the total amount of a polystyrene-based resin.

Another aspect of the present invention provides a resin sheet including a base sheet containing a thermoplastic resin, in which when performing dynamic viscoelasticity measurement, a storage modulus E'1 at 25°C is 1.0 × 10⁸ Pa or more and 1.0 × 10¹⁰ Pa or less, and a storage modulus E'2 at Loss Tangent Peak Temperature + 20°C is 1.0 × 10⁶ Pa or less.

By the resin sheet having the storage modulus E'1 and the storage modulus E'2 in the specific range, it is possible to have both of a characteristic that deformation due to a local load is less likely to occur and moldability that a compact can be obtained with a sufficient accuracy in the case of performing heat molding such as press molding. According to a carrier tape formed from such a resin sheet, in the use of transporting a miniaturized component, it is possible to include a favorably molded accommodation portion, sufficiently ensure deformation resistance to contact with a pickup nozzle, and suppress the occurrence of the pickup failure.

Another aspect of the present invention provides a container that is a compact of the resin sheet.

Another aspect of the present invention provides a carrier tape that is a compact of the resin sheet and is provided with an accommodation portion capable of accommodating a commodity.

Another aspect of the present invention provides an electronic component packaging including the carrier tape, an electronic component accommodated in the accommodation portion of the carrier tape, and a cover film adhering to the carrier tape as a lid material.

### Advantageous Effects of Invention

According to the present invention, it is possible to provide the resin sheet capable of obtaining the carrier tape, which is excellent in the deformation resistance to the local load while having sufficient moldability, and the container, the carrier tape, and the electronic component packaging obtained by using the resin sheet.

### Brief Description of Drawings

[FIG. 1] FIG. 1 is a schematic cross-sectional view illustrating an embodiment of a resin sheet.
[FIG. 2] FIG. 2 is a partially omitted perspective view illustrating one embodiment of a carrier tape.
[FIG. 3] FIG. 3 is a partially omitted perspective view illustrating one embodiment of an electronic component packaging.
[FIG. 4] FIG. 4 is a drawing for illustrating a method for evaluating moldability of a resin sheet.

### Description of Embodiments

Hereinafter, preferred embodiments of the present invention will be described in detail.

### [Resin Sheet]

A resin sheet of this embodiment includes a base sheet containing a thermoplastic resin. The resin sheet of this embodiment may further include a surface layer containing a conductive material and a thermoplastic resin, laminated on at least one surface of the base sheet.

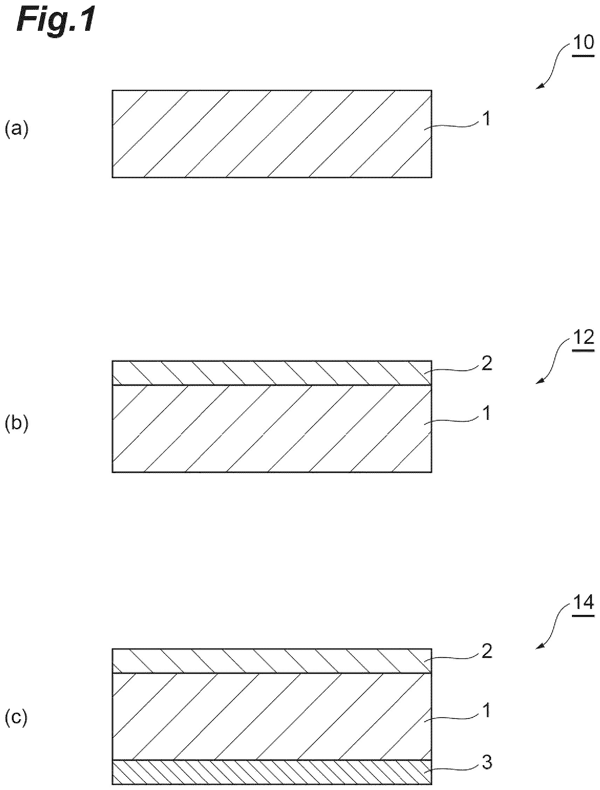

FIG. 1 is a schematic cross-sectional view illustrating an embodiment of the resin sheet of this embodiment. A resin sheet 10 illustrated in (a) in FIG. 1 is composed of a base sheet 1. A resin sheet 12 illustrated in (b) in FIG. 1 includes the base sheet 1, and a surface layer 2 provided on one surface of the base sheet 1. A resin sheet 14 illustrated in (c) in FIG. 1 includes the base sheet 1, the surface layer 2 laminated on one surface of the base sheet, and a second surface layer 3 laminated on the other surface of the base sheet. The surface layer 2 and the second surface layer 3 may have the same composition, or may have different compositions.

### (First Resin Sheet)

A resin sheet of this embodiment may include a base sheet containing a polystyrene-based resin (hereinafter, also referred to as a "first resin sheet").

In the first resin sheet, a maximum puncture elastic modulus calculated by the following procedure is 2.4 to 6.4 MPa.

### [Calculation Procedure of Maximum Puncture Elastic Modulus]

A measurement sample is fixed to a flat plate-shaped jig having a hole with a diameter of 1.0 mm provided in the center portion, a load L (N) and a strain amount ε in a puncture direction when perpendicularly puncturing the surface of the measurement sample with a needle having a tip in the shape of a circular flat surface (a diameter of 0.8 mm) at a rate of 0.5 mm/minute are measured under an environment of 23°C, and a value when a ratio of a stress difference to a strain amount difference calculated by Expression: (ΔL/S)/Δε (in the expression, S indicates the area (mm²) of the tip surface of the needle, and in the case of such a needle, S = 0.4 × 0.4 × π) is maximized at 0.1 ≤ ε ≤ 5.0 is set as the maximum puncture elastic modulus. Note that when a displacement amount in the puncture direction is set as D (mm), and the thickness of the resin sheet is set as t (mm), the strain amount ε is indicated by D/t.

The measurement sample may have a size of a length of 5 cm and a width of 5 cm. The puncture test can be implemented by using a tensile tester (manufactured by Toyo Seiki Seisaku-Sho, Ltd., Strograph VE-1D).

By the maximum puncture elastic modulus in the specific range, it is possible to have both of a characteristic that deformation due to a local load is less likely to occur and moldability that a compact can be obtained with a sufficient accuracy in the case of performing molding such as press molding. According to a carrier tape formed from such a resin sheet, in the use of transporting a miniaturized component, it is possible to include a favorably molded accommodation portion, sufficiently suppress deformation caused by contact with a pickup nozzle, and suppress the occurrence of the pickup failure.

From the viewpoint of making the moldability and deformation resistance to the local load compatible at a high level, in the first resin sheet, the maximum puncture elastic modulus may be 3.0 MPa or more and less than 6.2 MPa, or may be 4.0 MPa or more and less than 6.0 MPa.

In addition, in the puncture test, in a case where a load (a maximum load) measured when a fracture occurs is set as a puncture strength, from the viewpoint of the deformation resistance to the local load, in the first resin sheet, the puncture strength may be 7.0 to 14.0 N, or may be 8.0 to 13.0 N.

From the viewpoint of making the moldability and the deformation resistance to the local load compatible at a high level, in the first resin sheet, when performing dynamic viscoelasticity measurement, a storage modulus E'1 25°C may be 1.0 × 10⁸ Pa or more and 1.0 × 10¹⁰ Pa or less, and a storage modulus E'2 at Loss Tangent Peak Temperature (hereinafter, may be referred to as "Tg") + 20°C may be 1.0 × 10⁶ Pa or less. Note that the dynamic viscoelasticity measurement of the resin sheet is performed in the following condition.

A measurement sample is prepared by cutting the resin sheet to have a size of a length of 40 mm and a width of 3 mm. For such a measurement sample, the dynamic viscoelasticity measurement is performed in the following measurement condition by using a dynamic viscoelasticity analyzer RAS-G2 (manufactured by TA Instruments).

### [Measurement Condition]

Deformation Mode: a sinusoidal tension mode (linear tension)
Measurement Temperature: 20 to 200°C
Measurement Frequency: 1 Hz
Temperature Increase Rate: 10°C/min
Initial Value of Static Tensile Load: 0.2 N
Initial Distance (at 20°C) between Gaps: 10 mm

Note that in a case where the thickness of the resin sheet exceeds 1 mm, the dynamic viscoelasticity measurement may be performed by adjusting the width of the measurement sample to 3 to 10 mm.

From the viewpoint of further improving the deformation resistance to the local load, the storage modulus E'1 may be 1.0 × 10⁹ Pa or more.

From the viewpoint of further improving the moldability, the storage modulus E'2 may be 5.0 × 10⁵ Pa or less. In addition, from the viewpoint of suppressing the undesirable deformation of the sheet due to heating, the storage modulus E'2 may be 1.0 × 10³ Pa or more, or may be 1.0 × 10⁴ Pa or more.

Examples of the polystyrene-based resin contained in the base sheet include a general-purpose polystyrene resin, an impact-resistant polystyrene resin, and a copolymer of styrene and a monomer other than a styrene-based monomer. Only one type of such polystyrene-based resins can be used alone, or two or more types thereof can be used in combination.

The general-purpose polystyrene resin is a resin generally referred to as GPPS, and mainly contains styrene as a monomer, but may contain one or more types of aromatic vinyl compounds such as o-methyl styrene, p-methyl styrene, p-tert-butyl styrene, 1,3-dimethyl styrene, α-methyl styrene, vinyl naphthalene, vinyl anthracene, and 1,1-diphenyl ethylene as a trace component. As the general-purpose polystyrene resin, a commercially available resin can also be used.

The weight average molecular weight (Mw) of the general-purpose polystyrene resin may be 80000 to 220000, or may be 140000 to 220000. In this specification, the weight average molecular weight (Mw) can be obtained from a molecular weight distribution curve in terms of standard polystyrene obtained by an ordinary method using GPC.

The impact-resistant polystyrene resin is a resin generally referred to as HIPS, and a polystyrene resin containing particulate graft rubber in which a styrene-based monomer is grafted can be used. The styrene-based monomer mainly contains styrene, and may contain one or more types of the aromatic vinyl compounds other than styrene as a trace component. In the graft rubber, the styrene-based monomer is graft-copolymerized with a rubber component to form a graft branch, and as the rubber component in the graft rubber, for example, diene-based rubber containing 1,3-butadiene (butadiene), 2-methyl-1,3-butadiene (isoprene), 2,3-dimethyl-1,3-butadiene, 1,3-pentadiene, 1,3-hexadiene, 2-methyl pentadiene, and the like as a monomer is used. As the graft rubber, a thermoplastic elastomer of a styrene-conjugated diene block copolymer containing 50% by mass or more of a diene component can be used.

From the viewpoint of transparency, the particle size of the graft rubber in the impact-resistant polystyrene resin may be 2.0 µm or more and 3.0 µm or less, or may be 2.3 µm or more and 2.7 µm or less. Note that the particle size of the graft rubber indicates the average particle size of the graft rubber measured by a laser diffraction particle analyzer.

The weight average molecular weight (Mw) of the impact-resistant polystyrene resin may be 150000 to 210000, or may be 150000 to 190000.

Examples of the monomer other than the polystyrene-based monomer in the copolymer include a conjugated diene monomer, acrylonitrile, and methyl methacrylate. The conjugated diene monomer may be a compound having a conjugated double bond in the structure, and examples thereof include 1,3-butadiene (butadiene), 2-methyl-1,3-butadiene (isoprene), 2,3-dimethyl-1,3-butadiene, 1,3-pentadiene, 1,3-hexadiene, 2-methyl pentadiene, and the like.

Examples of the copolymer include a styrene-conjugated diene block copolymer, an AS resin, an ABS resin, an AES resin, a MS resin, and the like.

As the styrene-conjugated diene block copolymer, a polymer that contains a polymer block mainly containing a styrene-based monomer and a polymer block mainly containing a conjugated diene monomer in the structure can be used. The conjugated diene monomer may be a compound having a conjugated double bond in the structure, and examples thereof include 1,3-butadiene (butadiene), 2-methyl-1,3-butadiene (isoprene), 2,3-dimethyl-1,3-butadiene, 1,3-pentadiene, 1,3-hexadiene, 2-methyl pentadiene, and the like.

From the viewpoint of the moldability, in the first resin sheet, the base sheet may contain 50% by mass or more, 60% by mass or more, or 100% by mass of the polystyrene-based resin, on the basis of the total amount of resin components contained in the base sheet.

From the viewpoint of the moldability, in the first resin sheet, the base sheet may contain one or more types of resins of the general-purpose polystyrene resin and the impact-resistant polystyrene resin in a total of 50% by mass or more, or 60% by mass or more, on the basis of the total amount of the polystyrene-based resin.

From the viewpoint of imparting practical impact resistance to the resin sheet, the base sheet may contain the general-purpose polystyrene resin and the impact-resistant polystyrene resin, in which a mass ratio [GPPS : HIPS] thereof may be 0 : 100 to 90 : 10.

The base sheet may contain a conductive material, a filler, a plasticizer, a processing aid, an antioxidant, an antiblocking agent, and the like.

The thickness of the base sheet can be suitably set in accordance with the use thereof, and for example, may be 50 µm to 1 mm, may be 100 µm to 1 mm, or may be 150 to 600 µm.

The thickness of the base sheet can be 60 to 99% with respect to the thickness of the entire resin sheet. In a case where the surface layer is provided on both surfaces of the base sheet, the thickness of the base sheet may be 60 to 98% with respect to the thickness of the entire resin sheet. In a case where the surface layer is provided only on one surface of the base sheet, the thickness of the base sheet may be 60 to 99% with respect to the thickness of the entire resin sheet.

The first resin sheet may further include a surface layer containing a conductive material and a thermoplastic resin, laminated on at least one surface of the base sheet.

As the thermoplastic resin contained in the surface layer, a polystyrene-based resin, a polyolefin-based resin, a polycarbonate resin, and a polyester resin can be used. Only one type of such thermoplastic resins can be used alone, or two or more types thereof can be used in combination.

Examples of the polystyrene-based resin include the resins described above, and a hydrogenated styrene-based thermoplastic elastomer. Examples of the hydrogenated styrene-based thermoplastic elastomer include a polystyrene-poly(ethylene/propylene) block (SEP), polystyrene-poly(ethylene/propylene) block-polystyrene (SEPS), polystyrene-poly(ethylene/butylene) block-polystyrene (SEBS), polystyrene-poly(ethylene-ethylene/propylene) block-polystyrene (SEEPS), and the like.

Examples of the polyolefin-based resin include a polyethylene resin such as high-density polyethylene, very-low-density polyethylene, and linear low-density polyethylene; a polypropylene resin; an ethylene-αolefin copolymer obtained by copolymerization between ethylene and aolefin-based hydrocarbon having three or more carbon atoms, such as propylene, 1-butene, and 1-hexene; a copolymer of olefin and a monomer having a polar group that can be copolymerized with the olefin, and the like. Examples of the copolymer of the olefin and the monomer having a polar group that can be copolymerized with the olefin include an ethylene-vinyl acetate copolymer, an ethylene-acrylic acid copolymer, an ethylene-ethyl acrylate copolymer, an ethylene-methacrylic acid ester copolymer, an ethylene-vinyl acetate-vinyl chloride copolymer, a ternary copolymer with an acid anhydride, and the like.

Examples of the polycarbonate resin include an aromatic polycarbonate resin, an aliphatic polycarbonate resin, and an aromatic-aliphatic polycarbonate resin. The aromatic polycarbonate resin is generally classified into engineering plastic, and a resin obtained by polycondensation between general bisphenol A and phosgene or polycondensation between bisphenol A and carbonic acid ester can be used. The aromatic polycarbonate resin is preferable from the viewpoint of a mechanical strength.

As the polyester resin, a resin obtained by a polycondensation reaction between a dicarboxylic acid and diol can be used. Examples of the dicarboxylic acid include a phthalic acid, an isophthalic acid, a terephthalic acid, a 2-methyl terephthalate, 4,4'-diphenyl dicarboxylate, a 5-sulfoisophthalic acid, 2,6-naphthalene dicarboxylate, a malonic acid, a succinic acid, a glutaric acid, an adipic acid, a maleic acid, a maleic acid anhydride, and the like. Only one type of such dicarboxylic acids can be used alone, or two or more types thereof can be used in combination. Examples of the diol include ethylene glycol, diethylene glycol, polyethylene glycol, propylene glycol, polypropylene glycol, 1,3-propanediol, 1,4-butanediol, and the like. Only one type of such diols can be used alone, or two or more types thereof can be used in combination.

Examples of the conductive material contained in the surface layer include carbon black, graphite, CNT, black lead, Ketjen black, and the like. Only one type of such conductive materials can be used alone, or two or more types thereof can be used in combination.

The conductive material may be particles, and in such a case, the average primary particle size of the conductive material may be 10 nm to 5.0 µm, or may be 20 to 50 nm. Note that the average primary particle size of the particles is obtained by the following method.

First, a particle sample is dispersed in chloroform for 10 minutes in a condition of 150 kHz and 0.4 kW by using an ultrasonic disperser to prepare a dispersed sample. The dispersed sample is sprinkled and fixed onto a carbon reinforced support film and photographed with a transmission electron microscopy (manufactured by JEOL Ltd., JEM-2100). The particle sizes (maximum sizes in a case where the particles are in a shape other than a spherical shape) of 1000 or more particles are randomly measured using an Endter analyzer from an image magnified 50000 to 200000 times, and the average value thereof is set as the average primary particle size.

The content of the conductive material in the surface layer can be 10 to 30% by mass, and may be 15 to 25% by mass, on the basis of the total amount of the surface layer.

It is preferable that the surface resistivity of the surface layer is 10⁴ to 10⁸ Ω/square. In a case where the surface resistivity of the surface layer is in such a range, it is easy to prevent a damage on an electronic component due to static electricity, or a damage on an electronic component due to the inflow of electricity from the outside.

Various additives such as a lubricant, a plasticizer, and a processing aid can be added to the surface layer.

The thickness of the surface layer can be suitably set in accordance with the use thereof, and for example, may be 1 to 200 µm, may be 1 to 100 µm, or may be 2 to 50 µm.

### (Second Resin Sheet)

In a resin sheet of this embodiment, when performing dynamic viscoelasticity measurement, a storage modulus E'1 at 25°C may be 1.0 × 10⁸ Pa or more and 1.0 × 10¹⁰ Pa or less, and a storage modulus E'2 at Loss Tangent Peak Temperature (hereinafter, may be referred to as "Tg") + 20°C may be 1.0 × 10⁶ Pa or less (hereinafter, also referred to as a "second resin sheet"). Note that the dynamic viscoelasticity measurement of the resin sheet is performed in the condition described above.

In the second resin sheet having the storage modulus E'1 and the storage modulus E'2 in the specific range, it is possible to have both of the characteristic that the deformation due to the local load is less likely to occur and the moldability that the compact can be obtained with a sufficient accuracy in the case of performing the molding such as press molding.

A base sheet in the second resin sheet can be configured as with the base sheet in the first resin sheet. In addition, the second resin sheet may further include a surface layer containing a conductive material and a thermoplastic resin, laminated on at least one surface of the base sheet. In this case, the surface layer can be configured as with the surface layer in the first resin sheet.

The resin sheet of this embodiment can be molded into a shape according to the use by a known heat molding method such as a vacuum molding method, a pressure molding method, and a press molding method.

The resin sheet of this embodiment can be used as a material for a packaging container of an active component such as an IC, a component including the IC, a passive component such as a capacitor and a connector, and a mechanism component, and can be preferably used for a vacuum-molded tray, a magazine, a carrier tape with embossing (an embossed carrier tape), and the like.

### [Method for Producing Resin Sheet]

The resin sheet according to this embodiment can be produced by a general method. For example, the resin sheet can be produced by preparing, as a composition for forming a base layer for forming the base sheet, a mixture in which raw materials configuring the base sheet are mixed or a pellet obtained by kneading and pelletizing using a known method such as an extruder, and as necessary, as a composition for forming a surface layer for forming the surface layer, a mixture in which raw materials configuring the surface layer are mixed or a pellet in which the raw materials configuring the surface layer are kneaded and pelletized using a known method such as an extruder, and forming the resin sheet using such pellets by a known method such as an extruder. An extruder temperature, for example, can be set to 200 to 300°C.

In a case where the resin sheet includes the surface layer, the base sheet and the surface layer may be formed by molding each of the composition for forming a base layer and the composition for forming a surface layer into the shape of a sheet or a film with an individual extruder, and then, laminating the molded compositions in a stepwise manner by a heat laminating method, a dry laminating method, an extrusion laminating method, and the like, or may be formed by laminating the surface layer consisting of the composition for forming a surface layer on one surface or both surfaces of the base sheet molded in advance from the composition for forming a base layer by a method such as extrusion coating.

In addition, the resin sheet including the surface layer can be produced by supplying each of the raw materials (for example, the pellets) configuring the base sheet and the surface layer to an individual extruder by a multi-layer coextrusion method such as extrusion molding using a multi-layer T-die including a multi-manifold or T-die extrusion molding using a feed block. Such a method is preferable from the viewpoint that the resin sheet is obtained in one step.

### [Container]

A container according to this embodiment is a compact of the resin sheet according to this embodiment. The container can be obtained by molding the resin sheet according to this embodiment into a shape according to the use.

As a molding method, a known heat molding method such as a vacuum molding method, a pressure molding method, and a press molding method can be used.

Examples of a molding temperature include 120 to 200°C. In a case where the molding is performed using a metallic mold, for example, the resin sheet heated at a temperature higher than the loss tangent peak temperature may be put in the metallic mold and molded, and then, the compact may be released from the metallic mold at a temperature lower than the loss tangent peak temperature.

### [Carrier Tape]

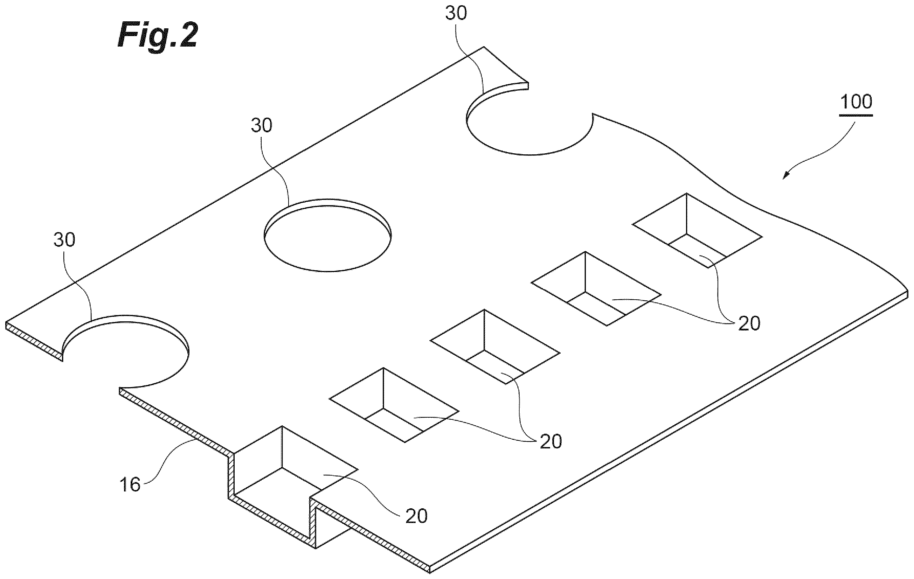

A carrier tape of this embodiment is a compact of the resin sheet according to this embodiment and is provided with an accommodation portion capable of accommodating a commodity. FIG. 2 is a perspective view illustrating one embodiment of the carrier tape. A carrier tape 100 illustrated in FIG. 2 is an embossed carrier tape consisting of a compact 16 of the resin sheet according to this embodiment, in which an accommodation portion 20 is provided by embossing molding. In the compact 16, a feed hole 30 that can be used for transporting various electronic components such as an IC in a sealing step or the like is provided.

The carrier tape according to this embodiment can be wound into the shape of a reel.

The carrier tape according to this embodiment is preferable as a packaging container of an electronic component. Examples of the electronic component include an IC, a light emitting diode (LED), a resistance, a liquid crystal, a capacitor, a transistor, a piezoelectric resistor, a filter, a crystal resonator, a crystal oscillator, a diode, a connector, a switch, a volume, a relay, an inductor, and the like. The electronic component may be an intermediate product using the component, or may be a final product.

According to the carrier tape formed from the resin sheet of this embodiment, in the use of transporting the miniaturized component, it is possible to include the favorably molded accommodation portion, and sufficiently suppress the deformation caused by the contact with the pickup nozzle.

### [Electronic Component Packaging]

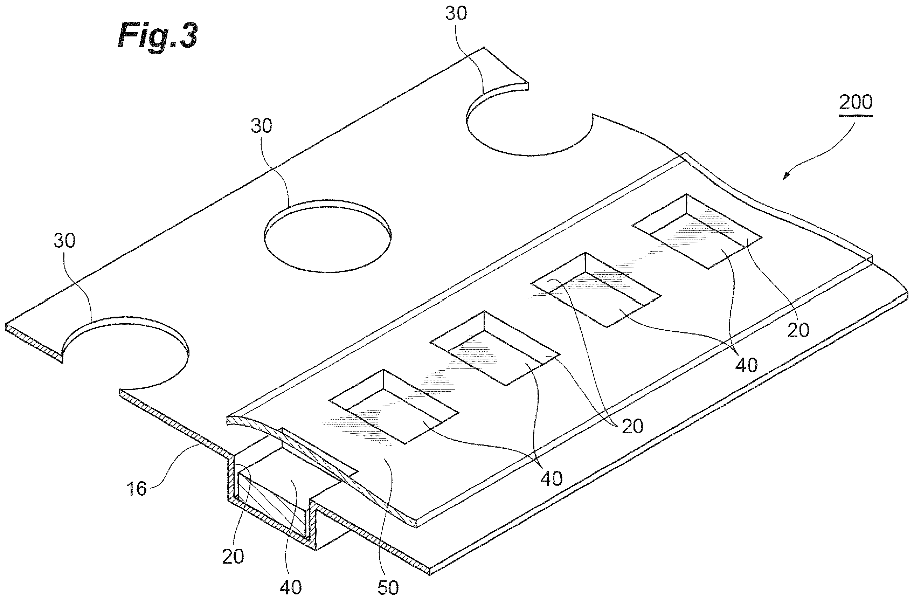

An electronic component packaging of this embodiment includes the carrier tape according to this embodiment, an electronic component accommodated in the accommodation portion of the carrier tape, and a cover film adhering to the carrier tape as a lid material. FIG. 3 is a partially omitted perspective view illustrating one embodiment of the electronic component packaging. An electronic component packaging 200 illustrated in FIG. 3 includes the embossed carrier tape consisting of the compact 16 of the resin sheet according to this embodiment, in which the accommodation portion 20 and the feed hole 30 are provided, an electronic component 40 accommodated in the accommodation portion 20, and a cover film 50 adhering to the embossed carrier tape.

Examples of the cover film include films disclosed in Japanese Patent No. 4630046 and Japanese Patent No. 5894578.

The cover film may adhere to the upper surface of the embossed carrier tape accommodating the electronic component by heat sealing.

The electronic component packaging of this embodiment can be used for storing and transporting the electronic component as a carrier tape body wound into the shape of a reel.

### Examples

Hereinafter, the present invention will be described in more detail by Examples and Comparative Examples, but the present invention is not limited to Examples described below.

### [Production of Resin Sheet]

### (Examples 1 to 9 and Comparative Examples 1 to 4)

Each of raw materials shown in Tables 1 and 2 was weighed to have a composition ratio (parts by mass) shown in the same tables, homogeneously mixed with a high-speed mixer, and then, kneaded using a vent-type twin-screw extruder with φ30 mm, and pelletized by a strand cutting method to obtain a resin composition for forming a surface layer.

On the other hand, each of raw materials shown in Tables 1 and 2 was weighed to have a composition ratio (parts by mass) shown in the same tables, and homogeneously mixed with a high-speed mixer to obtain a resin composition for forming a base sheet.

A resin sheet having a laminated structure of Surface Layer/Base Sheet/Surface Layer was produced using the pellet-shaped resin composition for forming a surface layer and the resin composition for forming a base sheet by a feed block method using a single-screw extruder (L/D = 28) with φ65 mm for forming the base sheet and a single-screw extruder (L/D = 26) with φ40 mm and a T-die with a width of 500 mm for forming the surface layer. Note that the thickness of the base sheet and the surface layer was adjusted such that the thickness of the resin sheet was 200 µm, and a thickness ratio of Surface Layer/Base Sheet/Surface Layer was 1 : 18 : 1.

The details of the raw materials shown in Tables 1 and 2 are as described below.
GPPS: a general-purpose polystyrene resin (manufactured by TOYO STYRENE Co., Ltd., Product Name "TOYO Styrol GP G200C")
HIPS: an impact-resistant polystyrene resin (manufactured by TOYO STYRENE Co., Ltd., Product Name "TOYO Styrol HI E640N")
EEA: an ethylene-ethyl acrylate copolymer resin (manufactured by ENEOS NUC Corporation, Product Name "DPDJ-6169")
HDPE: a high-density polyethylene resin (manufactured by Prime Polymer Co., Ltd., Product Name "HI-ZEX 5000H")
SEBS: a hydrogenated styrene-based thermoplastic elastomer (manufactured by Asahi Kasei Corp., Product Name "TUFTEC P2000")
SBC: a styrene-butadiene block copolymer (manufactured by Denka Company Limited, Product Name "CLEAREN 200TR")
ABS: an ABS resin (manufactured by Denka Company Limited, Product Name "DENKAABS SE-10")
PC: a polycarbonate resin (manufactured by TEIJIN LIMITED, Product Name "Panlite L-1225L")
PBT: a polybutylene terephthalate resin (manufactured by Mitsubishi Engineering-Plastics Corporation, Product Name "NOVADURAN 5010R8 M")
CB: carbon black (manufactured by Denka Company Limited, Product Name "DENKA BLACK GRANULE", an average primary particle size of 35 nm)

### [Evaluation of Resin Sheet]

Sampling was performed in the extrusion direction of the resin sheet, and evaluation was performed by the following method. The results thereof are collectively shown in Tables 1 and 2.

### (1) Puncture Strength and Maximum Puncture Elastic Modulus

A puncture strength and a maximum puncture elastic modulus were calculated by the following procedure.
(i) A measurement sample was prepared by cutting the resin sheet with a thickness of 0.2 mm to have a size of a length of 5 cm and a width of 5 cm.
(ii) The measurement sample was fixed to a flat plate-shaped jig having a hole with a diameter of 1.0 mm provided in the center portion, and the surface of the measurement sample was perpendicularly punctured with a needle having a tip in the shape of a circular flat surface (a diameter of 0.8 mm) at a rate of 0.5 mm/minute from the upper side of the measurement sample to measure a load L (N) and a strain amount ε in a puncture direction by using a tensile tester (manufactured by Toyo Seiki Seisaku-Sho, Ltd., Strograph VE-1D) under an environment of 23°C. Note that when a displacement amount in the puncture direction is set as D (mm), and the thickness of the resin sheet is set as t (mm), the strain amount ε is indicated by D/t.
(iii) A value when a ratio of a stress difference to a strain amount difference calculated by Expression: (ΔL/S)/Δε (in the expression, S indicates the area (mm²) of the tip surface of the needle) is maximized at 0.1 ≤ ε ≤ 5.0 (that is, 0.02 mm ≤ D ≤ 1.0 mm) was set as the maximum puncture elastic modulus. In addition, a load (a maximum load) measured when a fracture occurs was set as the puncture strength.

### (2) Dynamic Viscoelasticity of Resin Sheet

A measurement sample was prepared by cutting the resin sheet with a thickness of 0.2 mm to have a size of a length of 40 mm and a width of 3 mm. For such a measurement sample, dynamic viscoelasticity measurement was performed in the following measurement condition by using a dynamic viscoelasticity analyzer RAS-G2 (manufactured by TA Instruments) to calculate a storage modulus E'1 at 25°C and a storage modulus E'2 at Loss Tangent (tanδ) Peak Temperature Tg + 20°C, respectively.

### [Measurement Condition]

Deformation Mode: a sinusoidal tension mode (linear tension)
Measurement Temperature: 20 to 200°C
Measurement Frequency: 1 Hz
Temperature Increase Rate: 10°C/min
Initial Value of Static Tensile Load: 0.2 N
Initial Distance (at 20°C) between Gaps: 10 mm

### (3) Component Pressing Evaluation

An evaluation sample was prepared by cutting the resin sheet with a thickness of 0.2 mm to have a size of a length of 5 cm and a width of 5 cm. Four laminated ceramic capacitors (Size: 0.4 mm × 0.2 mm, a height of 0.2 mm) were placed on the surface of the evaluation sample such that the laminated ceramic capacitors were positioned at four corners of a square with 2 cm square, and a SUS plate with a length of 5 cm, a width of 5 cm, a thickness of 0.2 mm, and a weight of 4.0 g was placed thereon. Further, weights with 100 g to 1000 g were placed on the SUS plate and left to stand for 1 minute, and then, the amount of dent on the surface of the evaluation sample was measured with a laser microscope VK-X100 (manufactured by KEYENCE CORPORATION). The heaviness of the weight when the amount of dent is 5 µm or more (hereinafter, referred to as a "dent load") was checked, and deformation resistance to a load on a minimum area was evaluated by the following determination criteria. Note that since the laminated ceramic capacitor includes electrodes (a length of 0.1 mm) on both ends, and a size between the electrodes is small, the electrode portion is in contact with the resin sheet.

### <Determination Criteria>

A: The dent load exceeds 1000 g (when the heaviness of the weight is 1000 g, the amount of dent on the surface of the resin sheet is less than 5 µm)
B: The dent load is 800 g or more and 1000 g or less
C: The dent load is 500 g or more and less than 800 g
D: The dent load is less than 500 g

### (4) Evaluation of Moldability

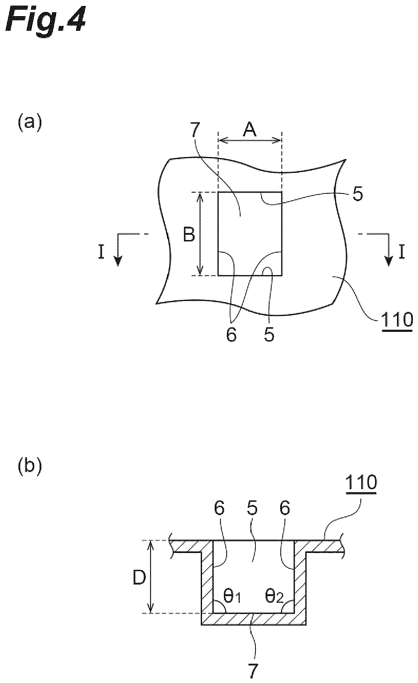

The resin sheet with a thickness of 0.2 mm was slit to have a width of 8 mm, and in a press molding machine, both surfaces of the sheet were heated with a contact heater at Tg°C + 20°C, which is calculated by (2) described above, and then, five containers, in which the size of an opening portion is (a dimension A) 0.23 mm × (a dimension B) 0.43 mm, and a depth (D) is 0.25 mm, were molded by an upper mold and a lower mold (refer to FIG. 4). Note that (a) in FIG. 4 is a top view of the container, and (b) in FIG. 4 is a schematic cross-sectional view taken along line I-I in (a) in FIG. 4. A container 110 illustrated in FIG. 4 is in a concave shape having a bottom wall portion 7 and lateral wall portions 5 and 6 erected from the edge of the bottom wall portion 7. In addition, the upper mold is designed such that angles θ1 and θ2 between the inner surface of the bottom wall portion 7 and the inner surfaces of the lateral wall portions 6 were right angles. The sectional surface in the dimension A (refer to (b) in FIG. 4) obtained by cutting the center portion in the dimension B of the obtained container was observed with a laser microscope VK-X100 (manufactured by KEYENCE CORPORATION), an angle (θ) between the bottom surface and the lateral surface inside the container was measured at two spots, and the average value of the angles measured at a total of 10 spots was set as a pocket angle θp. From the obtained pocket angle θp, moldability was evaluated by the following determination criteria.

### <Determination Criteria>

A: The pocket angle θp is less than 92.0°
B: The pocket angle θp is 92.0° or more and less than 94.0°
C: The pocket angle θp is 94.0° or more and less than 96.0°
D: The pocket angle θp is 96.0° or more

**[Table 1]**

| | | | Example 1 | Example 2 | Example 3 | Example 4 | Example 5 | Example 6 | Example 7 |
|---|---|---|---|---|---|---|---|---|---|
| | Surface layer | GPPS | 50 | 50 | 50 | 50 | - | - | - |
| | | HIPS | 10 | 10 | 10 | 10 | 60 | 60 | 60 |
| | | EEA | 9 | 9 | 9 | 9 | 9 | 9 | 9 |
| | | HDPE | 8 | 8 | 8 | 8 | 8 | 8 | 8 |
| | | SEBS | 3 | 3 | 3 | 3 | 3 | 3 | 3 |
| | | PC | - | - | - | - | - | - | - |
| Composition | | PBT | - | - | - | - | - | - | - |
| | | CB | 20 | 20 | 20 | 20 | 20 | 20 | 20 |
| | Base sheet | GPPS | 50 | 30 | 10 | 40 | 80 | 50 | 10 |
| | | HIPS | 15 | 60 | 80 | 10 | 10 | 15 | 80 |
| | | SBC | 35 | 10 | 10 | 50 | 10 | 35 | 10 |
| | | ABS | - | - | - | - | - | - | - |
| | | PC | - | - | - | - | - | - | - |
| Thickness (µm) of entire resin sheet | | | 200 | 200 | 200 | 200 | 200 | 200 | 200 |
| Thickness (µm) of surface layer (one side) | | | 10 | 10 | 10 | 10 | 10 | 10 | 10 |
| Puncture test | Puncture strength (N) | | 10.7 | 9.8 | 7.1 | 11.2 | 9.1 | 11.1 | 9.4 |
| | Maximum puncture elastic modulus (MPa) | | 5.7 | 4.7 | 3.0 | 5.9 | 4.0 | 5.6 | 2.7 |
| Dynamic viscoelastic characteristic | tan8 peak temperature (°C) | | 110 | 108 | 109 | 111 | 108 | 109 | 109 |
| | Storage modulus E'1 (Pa) | | 2.16 × 10⁹ | 1.99 × 10⁹ | 9.27 × 10⁸ | 3.01 × 10⁹ | 1.29 × 10⁹ | 1.38 × 10⁹ | 6.44 × 10⁸ |
| | Storage modulus E'2 (Pa) | | 3.68 × 10⁵ | 2.01 × 10⁵ | 1.87 × 10⁵ | 5.71 × 10⁵ | 3.98 × 10⁵ | 4.05 × 10⁵ | 1.93 × 10⁵ |
| Component pressing evaluation | Dent load (g) | | > 1000 | > 1000 | 750 | > 1000 | 950 | > 1000 | 700 |
| | Determination | | A | A | C | A | B | A | C |
| Moldability | Pocket angle θp (°) | | 91.9 | 91.2 | 91.3 | 92.9 | 91.1 | 92.0 | 91.8 |
| | Determination | | A | A | A | B | A | A | A |

**[Table 2]**

| | | | Example 8 | Example 9 | Example 10 | Comparative Example 1 | Comparative Example 2 | Comparative Example 3 | Comparative Example 4 | Comparative Example 5 |
|---|---|---|---|---|---|---|---|---|---|---|
| | Surface layer | GPPS | - | - | - | - | - | - | - | - |
| | | HIPS | - | 60 | - | 55 | 60 | - | - | - |
| | | EEA | - | 9 | - | 14 | 9 | - | - | - |
| | | HDPE | - | 8 | - | 8 | 8 | - | - | - |
| | | SEBS | - | 3 | - | 3 | 3 | - | - | - |
| | | PC | - | - | 60 | - | - | - | 80 | 60 |
| Composition | | PBT | - | - | 20 | - | - | - | | 20 |
| | | CB | - | 20 | 20 | 20 | 20 | - | 20 | 20 |
| | Base sheet | GPPS | 60 | - | 50 | 10 | - | 30 | - | - |
| | | HIPS | 20 | - | 15 | 80 | 100 | 10 | - | - |
| | | SBC | 20 | - | 35 | 10 | - | 60 | - | - |
| | | ABS | - | 100 | - | - | - | - | 100 | - |
| | | PC | - | - | - | - | - | - | - | 100 |
| Thickness (µm) of entire resin sheet | | | 200 | 200 | 200 | 200 | 200 | 200 | 200 | 200 |
| Thickness (µm) of surface layer (one side) | | | 0 | 10 | 10 | 10 | 10 | 0 | 10 | 10 |
| Puncture test | Puncture strength (N) | | 11.4 | 12.6 | 12.9 | 7.8 | 8.6 | 9.1 | 13.8 | 14.1 |
| | Maximum puncture elastic modulus (MPa) | | 3.52 | 4.6 | 6.1 | 1.9 | 2.0 | 2.2 | 6.6 | 7.0 |
| Dynamic viscoelastic characteristic | tanδ peak temperature (°C) | | 111 | 119 | 107 | 108 | 110 | 111 | 119 | 120 |
| | Storage modulus E'1 (Pa) | | 2.11 × 10⁹ | 2.70 × 10⁹ | 1.78 × 10⁹ | 3.99 × 10⁸ | 5.12 × 10⁸ | 1.01 × 10⁹ | 2.17 × 10⁹ | 3.41 × 10⁹ |
| | Storage modulus E'2 (Pa) | | 4.17 × 10⁵ | 8.76 × 10⁵ | 6.91 × 10⁵ | 2.03 × 10⁵ | 1.86 × 10⁵ | 8.48 × 10⁵ | 5.32 × 10⁶ | 6.85 × 10⁶ |
| Component pressing evaluation | Dent load (g) | | > 1000 | > 1000 | > 1000 | 400 | 450 | 450 | > 1000 | > 1000 |
| | Determination | | A | A | A | D | D | D | A | A |
| Moldability | Pocket angle θp (°) | | 92.0 | 93.1 | 93.4 | 91.6 | 91.4 | 96.1 | 96.8 | 97.6 |
| | Determination | | A | B | B | A | A | C | D | D |

### Reference Signs List

1: base sheet, 2: surface layer, 3: second surface layer, 5, 6: lateral wall portion, 7: bottom wall portion, 10, 12, 14: resin sheet, 20: accommodation portion, 30: feed hole, 40: electronic component, 50: cover film, 100: carrier tape, 200: electronic component packaging.

## Claims

1. A resin sheet, comprising
a base sheet containing a polystyrene-based resin,
wherein a maximum puncture elastic modulus calculated by a procedure described below is 2.4 to 6.4 MPa,
[Calculation Procedure of Maximum Puncture Elastic Modulus]
a measurement sample is fixed to a flat plate-shaped jig having a hole with a diameter of 1.0 mm provided in a center portion, a load L (N) and a strain amount ε in a puncture direction when perpendicularly puncturing a surface of the measurement sample with a needle having a tip in the shape of a circular flat surface (a diameter of 0.8 mm) at a rate of 0.5 mm/minute are measured under an environment of 23°C, and a value when a ratio of a stress difference to a strain amount difference calculated by Expression: (ΔL/S)/Δε (in the expression, S indicates an area (mm²) of a tip surface of the needle) is maximized at 0.1 ≤ ε ≤ 5.0 is set as the maximum puncture elastic modulus.

2. The resin sheet according to claim 1,
wherein when performing dynamic viscoelasticity measurement, a storage modulus E'1 at 25°C is 1.0 × 10⁸ Pa or more and 1.0 × 10¹⁰ Pa or less, and a storage modulus E'2 at Loss Tangent Peak Temperature + 20°C is 1.0 × 10⁶ Pa or less.

3. The resin sheet according to claim 1,
wherein the base sheet contains one or more types of resins of a general-purpose polystyrene resin and an impact-resistant polystyrene resin in a total of 50% by mass or more, on the basis of a total amount of a styrene-based resin.

4. A resin sheet, comprising
a base sheet containing a thermoplastic resin,
wherein when performing dynamic viscoelasticity measurement, a storage modulus E'1 at 25°C is 1.0 × 10⁸ Pa or more and 1.0 × 10¹⁰ Pa or less, and a storage modulus E'2 at Loss Tangent Peak Temperature + 20°C is 1.0 × 10⁶ Pa or less.

5. A container that is a compact of the resin sheet according to any one of claims 1 to 4.

6. A carrier tape that is a compact of the resin sheet according to any one of claims 1 to 4 and is provided with an accommodation portion capable of accommodating a commodity.

7. An electronic component packaging, comprising:
the carrier tape according to claim 6;
an electronic component accommodated in the accommodation portion of the carrier tape; and
a cover film adhering to the carrier tape as a lid material.
